Europäisches Patentamt

European Patent Office

Office européen des brevets

(19)

(11) Veröffentlichungsnummer : **0 121 721**
**B1**

(12) **EUROPÄISCHE PATENTSCHRIFT**

(45) Veröffentlichungstag der Patentschrift :
23.12.87

(21) Anmeldenummer : 84102040.7

(22) Anmeldetag : 27.02.84

(51) Int. Cl.⁴ : **G 11 C 8/00**

(54) Schaltungsanordnung zur Auswahl von mindestens einer Bit-Leitung bei einem MOS Speicher.

(30) Priorität : 07.03.83 DE 3307953

(43) Veröffentlichungstag der Anmeldung :
17.10.84 Patentblatt 84/42

(45) Bekanntmachung des Hinweises · auf die Patenterteilung : 23.12.87 Patentblatt 87/52

(84) Benannte Vertragsstaaten :
AT CH DE FR IT LI

(56) Entgegenhaltungen :
US-A- 4 006 458
US-A- 4 318 014

(73) Patentinhaber : **Siemens Aktiengesellschaft Berlin und München**
**Wittelsbacherplatz 2**
**D-8000 München 2 (DE)**

(72) Erfinder : **Horninger, Karlheinrich, Dr.**
**Riederinger Strasse 9**
**D-8011 Egiharting (DE)**

EP 0 121 721 B1

## Beschreibung

Die Erfindung bezieht sich auf eine Schaltungsanordnung zur Auswahl von mindestens einer Bit-Leitung bei einem MOS Speicher, bei dem an den Bit-Leitungen Speicherzellen angeschlossen sind.

Der Aufbau von MOS Speichern ist bekannt. Aus Siemens Forschung- und Entwicklungsberichte Bd. 11, 1982, Nr. 4, Seite 199 bis 203 ergibt sich ein statischer MOS Speicher, bei dem zwischen Bit-Leitungen und Wortleitungen jeweils Speicherzellen angeordnet sind. Beim Lesevorgang werden die Bit-Leitungen vorgeladen, dann über Wortleitungen die gewünschten Speicherzellen ausgewählt, die die vorgeladenen Bit-Leitungen entladen oder nicht entladen. Die dadurch auf den Bit-Leitungen eintretenden Potentialänderungen werden über Transfertransistoren, deren gesteuerte Strecke (Source-Drain-Strecke) in den Bit-Leitungen angeordnet sind zu einem Leseverstärker übertragen. Die Steuereingänge (Gate) der Transfertransistoren sind mit Leitungen verbunden, die zu einem Bit-Decoder führen. Der Bit-Decoder wählt eine dieser Adressenleitungen entsprechend einer Bit-Leitungsadresse aus.

Bei der angegebenen Literaturstelle ist ein Statischer MOS Speicher beschrieben. Bei dynamischen MOS Speichern liegen die Speicherzellen ebenfalls zwischen Bit-Leitungen und Wortleitungen. Dasselbe gilt für MOS Festspeicher. Derartige Speicherzellen sind der Literatur allgemein bekannt. Auch bei Speichern mit derartigen Speicherzellen wird die beim Auslesen der Speicherzelle auf der Bit-Leitung eintretende Potentialänderung über Transfertransistoren zu einem Leseverstärker übertragen.

Da die Bit-Leitungen, die eine große kapazitive Last darstellen, von kleinen Speichertransistoren in der Speicherzelle entladen werden müssen, ist die effektive Spannung am Steuereingang (Gate-Spannung) am Transfertransistor sehr klein und der Transfertransistor leitet nur schwach. Überdies hat auch das Ansteuersignal auf der Adressenleitung zu den Transfertransistoren eine endliche Anstiegszeit, so daß die Potentialänderung auf der Bit-Leitung nur sehr langsam über den Transfertransistor an den Eingang eines Leseverstärkers übertragen wird. Die Folge ist, daß die Zugriffszeit zum Speicher nicht unwesentlich erhöht wird.

Die der Erfindung zugrundeliegende Aufgabe besteht darin, eine Schaltungsanordnung zur Auswahl von mindestens einer Bit-Leitung bei einem MOS Speicher anzugeben, bei der die Übertragung des Signals über die Bit-Leitung zum Leseverstärker durch den Auswahlvorgang nicht wesentlich zeitlich beeinflußt wird. Diese Aufgabe wird bei einer Schaltungsanordnung der eingangs angegebenen Art dadurch gelöst, daß zwischen jeder Bit-Leitung und einem Betriebspotential die gesteuerte Strecke eines Auswahltransistors angeordnet ist, dessen Steuereingang mit einer Adreßleitung verbunden ist, über die an dem Auswahltransistor bei Auswahl der Bit-Leitung ein Sperrpotential, bei Nichtauswahl ein den Auswahltransistor leitend steuerndes Potential anliegt.

Sollen mehrere Bit-Leitungen zusammengefaßt einer Verstärkerschaltung bzw. Treiberschaltung zugeführt werden, dann kann zwischen den Bit-Leitungen und der Verstärker/Treiberschaltung eine Verknüpfungsschaltung, z. B. ein NOR Glied, angeordnet werden. Die Verknüpfungsschaltung kann derart ausgeführt sein, daß nur die Potentialänderung auf der ausgewählten Bit-Leitung zur Verstärker/Treiberschaltung gelangen kann, die übrigen Bit-Leitungen jedoch die Verstärker/Treiberschaltung nicht beeinflussen können.

Da nun die Transistoren, die zur Auswahl der Bit-Leitung verwendet werden, nicht mehr in der Bit-Leitung liegen und bei der ausgewählten Bit-Leitung zudem im Sperrzustand sind, wird die Geschwindigkeit der Übertragung der durch die ausgewählte Speicherzelle bedingten Potentialänderung über die Bitleitung durch den Transistor nicht mehr beeinflußt. Die Folge ist, daß die Zugriffszeit zum Speicher erheblich verkürzt wird.

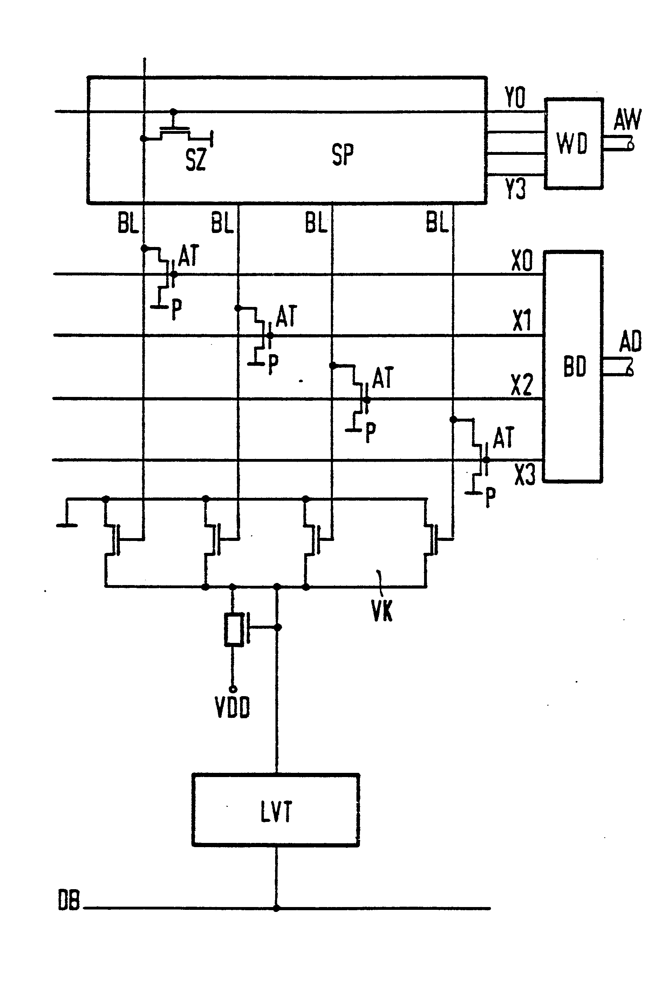

An Hand eines Ausführungsbeispiels, das in der Figur dargestellt ist, wird die Erfindung weiter erläutert. Im Ausführungsbeispiel der Figur ist nur die erfindungsgemäße Schaltungsanordnung ausführlicher dargestellt, die übrigen Teile des MOS Speichers, die bekannt sind, sind nur als Block gezeichnet. Die Ausführung dieser Blöcke können der Literatur, z. B. der eingangs angegebenen Literaturstelle, entnommen werden.

Ein Speicher SP enthält Speicherzellen, die zwischen Wortleitungen Y und Bit-Leitungen BL angeordnet sind. Als Beispiele von Speicherzellen ist in der Figur eine Speicherzelle SZ angegeben, die bei einem Festspeicher verwendet werden kann. Zwischen den übrigen Wortleitungen Y und den Bit-Leitungen BL können ebenfalls derartige Speicherzellen SZ liegen, oder bei einem Festspeicher auch fehlen. Wird ein derartiger Speicher ausgelesen, z. B. die Speicherzelle SZ, dann wird von einem Wortdecoder WD in Abhängigkeit der Wortleitungsadresse AW die Adressenleitung oder Wortleitung YO ausgewählt und die Speicherzelle SZ angesteuert. Die Speicherzelle SZ entlädt die vorgeladene Bit-Leitung BL und verursacht damit eine Potentialänderung auf der Bit-Leitung BL. Diese Potentialänderung wird dann zu einer Leseverstärker und Treiberschaltung LVT übertragen, wenn die Bit-Leitung ausgewählt worden ist.

Die Auswahl der Bit-Leitung erfolgt mit Hilfe eines Bit-Decoders BD, dem eine Bit-Leitungsadresse AD zugeführt wird. Vom Bit-Decoder BD führen Adressenleitungen X0 bis X3 zu Auswahltransistoren AT, die an den Bit-Leitungen BL angeschlossen sind. Dabei liegen die gesteuerten Strecken (Source-Drain-Strecke) der Auswahltransistoren AT zwischen der Bit-Leitung BL und einem Betriebspotential P. Der Steuereingang (Gate) ist dagegen mit der Adressenleitung X0 bis X3 verbunden.

Soll eine Bit-Leitung BL ausgewählt werden und damit die Potentialänderung auf der Bit-Leitung zur Leseverstärker- und Treiberschaltung LVT übertragen werden, dann wird über die Adressenleitung z. B. X0 an den Auswahltransistor AT ein Sperrpotential angelegt und dieser damit im Sperrzustand gehalten. Über alle übrigen Adressenleitungen, die zu Auswahltransistoren führen, die an nicht ausgewählten Bit-Leitungen liegen, wird ein Potential an die Auswahltransistoren angelegt, das diese Transistoren in den leitenden Zustand bringt. Diese nicht ausgewählten Bit-Leitungen werden damit ca. auf das Betriebspotential P umgeladen. Die ausgewählte Bit-Leitung BL dagegen wird durch den zugeordneten gesperrten Auswahltransistor AT nicht beeinflußt.

Die Bit-Leitungen BL können mit Hilfe einer Verknüpfungsschaltung VK, z. B. einem NOR Glied, zusammengefaßt werden und der Leseverstärker/Treiberschaltung LVT zugeführt werden. Das Verknüpfungsglied VK ist derart aufgebaut, daß nur die Potentialänderung auf der ausgewählten Bit-Leitung zur Leseverstärker/Treiberschaltung LVT gelangen kann, nicht jedoch die Potentiale der übrigen nicht ausgewählten Bit-Leitungen. Diese Leseverstärker- und Treiberschaltung LVT gibt dann das verstärkte Signal auf eine Datenleitung DB weiter.

Das Betriebspotential P an den Auswahltransistoren AT muß so gewählt sein, daß das Potential auf den nicht ausgewählten Bit-Leitungen beim Auswahlvorgang die den Bit-Leitungen nachgeschaltete Verknüpfungsschaltung oder nachgeschaltete Leseverstärker nicht beeinflußt, so daß nur das Potential auf der ausgewählten Bit-Leitung das nachgeschaltete Verknüpfungsglied oder einen nachgeschalteten Leseverstärker beeinflussen kann. Im Ausführungsbeispiel ist das Betriebspotential P mit 0 Volt gewählt und dementsprechend ist auch der eine Anschluß des Verknüpfungsgliedes VK mit 0 Volt verbunden. Bei Nichtauswahl von Bit-Leitungen laden die Auswahltransistoren AT die Bit-Leitungen auf 0 Volt um und dem entsprechend wird das Verknüpfungsglied VK durch diese Bit-Leitungen nicht mehr beeinflußt. Beeinflußt bleibt nur der Transistor des Verknüpfungsgliedes VK, der mit der ausgewählten Bit-Leitung verbunden ist. Entsprechend dem Potential auf der ausgewählten Bit-Leitung für binär 0 oder binär 1 ist dieser Transistor leitend oder nichtleitend und dementsprechend liegt am Ausgang des Verknüpfungsgliedes VK entweder ca. 0 Volt oder ca. ein Potential VDD.

**Patentansprüche**

1. Schaltungsanordnung zur Auswahl von mindestens einer Bit-Leitung bei einem MOS-Speicher, bei dem an den Bit-Leitungen Speicherzellen angeschlossen sind, dadurch gekennzeichnet, daß zwischen jeder Bit-Leitung (BL) und einem Betriebspotential (P) ein Auswahltransistor (AT) angeordnet ist, dessen Steuereingang mit einer Adressenleitung (X) verbunden ist, über die an dem Auswahltransistor bei Auswahl der Bit-Leitung ein Sperrpotential, bei Nichtauswahl ein den Auswahltransistor leitend steuerndes Potential anliegt.

2. Schaltungsanordnung nach Anspruch 1, dadurch gekennzeichnet, daß die Bit-Leitungen (BL) über ein Verknüpfungsglied (VK) an eine Verstärker/Treiberschaltung (LVT) angeschlossen sind.

3. Schaltungsanordnung nach Anspruch 2, dadurch gekennzeichnet, daß das Verknüpfungsglied (VK) ein Mehrfach-NOR-Glied ist.

**Claims**

1. A circuit arrangement for selecting at least one bit line in an MOS-store, in which the bit lines are connected to storage cells, characterised in that between each bit line (BL) and an operating potential (P) is arranged a selector transistor (AT) whose control input is connected to an address line (X) via which, when the bit-line is selected, a blocking potential is connected to the selector, transistor and when the bit-line is not selected a potential is connected to the selector transistor by which it is rendered conductive.

2. A circuit arrangement as claimed in claim 1, characterised in that the bit lines (BL) are connected to an amplifier/driver circuit (LVT) via a logic-linking element (VK).

3. A circuit arrangement as claimed in claim 2, characterised in that the logic-linking element (VK) is a multiple-NOR-gate.

**Revendications**

1. Montage pour la sélection d'au moins une ligne de bit dans une mémoire MOS comportant des cellules de mémorisation connectées aux lignes de bit, caractérisé en ce qu'un transistor de sélection (AT) est disposé entre chaque ligne de bit (BL) et un potentiel de service (P), transistor dont l'entrée de commande est reliée à une ligne d'adresses (X) par laquelle le transistor de sélection reçoit un potentiel de blocage en cas de sélection de cette ligne de bit et reçoit un potentiel qui le fait passer à l'état conducteur lorsque la ligne n'est pas sélectée.

2. Montage selon la revendication 1, caractérisé en ce que les lignes de bit (BL) sont connectées à travers un élément logique (VK) à un amplificateur/circuit d'attaque (LVT).

3. Montage selon la revendication 2, caractérisé en ce que l'élément logique (VK) est un élément NOR multiple.